# EUROPEAN PATENT APPLICATION

(11) **EP 4 465 785 A1**
(43) Date of publication of application: **20.11.2024**
(21) Application number: 22920400.3
(22) Date of filing: 12.10.2022
(51) Int. Cl.: H05K 13/02, H05K 5/00

(54) **CASE**

(30) Priority: 12.01.2022 JP 2022003089
(71) Applicant: Murata Manufacturing Co., Ltd., Nagaokakyo-shi, Kyoto 617-8555 (JP)
(72) Inventor: SERITA Noboru, Nagaokakyo-shi, Kyoto 617-8555 (JP)
(74) Representative: Zimmermann, Tankred Klaus
(86) International application number: PCT/JP2022/038045
(87) International publication number: WO 2023/135877

(57) **Abstract**

Provided is a case that reduces the tendency of components accommodated therein to be lost and facilitates smooth discharge of the components through a discharge port. A case 1 includes: a case body 10 having a discharge port 19 through which a plurality of accommodated electronic components M are discharged; an upper guide slit 41 and a lower guide slit 51 communicating with the discharge port 19; and a shutter member 30 slidably inserted into the guide slits and configured to open and close the discharge port 19. The case body 10 has a front inner wall surface 14a1 and a rear inner wall surfaces 14b1 as a pair of inner wall surfaces facing each other to define the upper guide slit 41 therebetween and a lower inner wall surface 13a1 and an upper inner wall surface 17b1 as a pair of inner wall surfaces defining the lower guide slit 51 therebetween. The shutter member 30 has a first main surface 38a and a second main surface 38b, and includes thereon an urging member 70 that elastically urges the shutter member 30 toward at least one of the pair of the inner wall surfaces.

## Description

### TECHNICAL FIELD

The present invention relates to a case for accommodating electronic components such as chip components.

### BACKGROUND ART

mounting device is used to mount an electronic component at a predetermined position on a board. It is necessary to individually supply electronic components to such a mounting device. For example, Japanese Unexamined Patent Application, Publication No. 2009-295618 discloses a case that accommodates a number of electronic components in bulk, and has, at a bottom thereof, a discharge port through which the electronic components are allowed to fall under their own weight onto a feeder. The feeder supplies the electronic components individually to a mounting device.

Patent Document 1: Japanese Unexamined Patent Application, Publication No. 2009-295618

### DISCLOSURE OF THE INVENTION

### Problems to be Solved by the Invention

In a case where the case of this type includes an opening/closing member that opens and closes the discharge port, minute electronic components may enter a gap between the opening/closing member and the case, so that the minute electronic components may be lost and/or may be prevented from being smoothly discharged.

Embodiments of the present invention provide a case that reduces the tendency of components accommodated therein to be lost and facilitates smooth discharge of the components through a discharge port.

### Means for Solving the Problems

A case according to an embodiment of the present invention includes; a case body configured to accommodate a plurality of components and having a discharge port through which the components are discharged; a guide slit formed in the case body and communicating with the discharge port; and a shutter member slidably inserted into the guide slit and configured to slide to open and close the discharge port. The case body had a pair of inner wall surfaces that face each other and define the guide slit therebetween. The shutter member has a pair of main surfaces that face the pair of inner wall surfaces, respectively, and includes an urging member. The urging member is configured to elastically urge the shutter member toward at least one of the pair of the inner wall surfaces.

### Effects of the Invention

Embodiments of the present invention provides a case that reduces the tendency of components accommodated therein to be lost and facilitates smooth discharge of the components through a discharge port.

### BRIEF DESCRIPTION OF THE DRAWINGS

FIG. 1 is a perspective view of a case according to a first embodiment as viewed from below.
FIG. 2 is a front view of the case according to the first embodiment.
FIG. 3 is a bottom view of the case according to the first embodiment.
FIG. 4 is a diagram illustrating the interior of the case according to the first embodiment as viewed from a side.
FIG. 5 is diagram illustrating the interior of a front portion of the case according to the first embodiment in an open state in which a discharge port of the case is open, as viewed from a side.
FIG. 6 is a partial cross-sectional view illustrating the portion VI in FIG. 5 on an enlarged scale.
FIG. 7 is a partial cross-sectional view taken along the line VII-VII in FIG. 6.
FIG. 8 is a plan view of a shutter member according to the first embodiment.
FIG. 9 is a cross-sectional view illustrating a lower urging member according to a second embodiment, and corresponding to the cross section taken along the line VII-VII in FIG. 6.
FIG. 10 is a cross-sectional view illustrating a lower urging member according to a third embodiment, and corresponding to the cross section taken along the line VII-VII in FIG. 6.
FIG. 11 is a cross-sectional view illustrating a lower urging member according to a fourth embodiment, and corresponding to the cross section taken along the line VII-VII in FIG. 6.
FIG. 12 is a cross-sectional view illustrating a lower urging member according to a fifth embodiment, and corresponding to the cross section taken along the line VII-VII in FIG. 6.
FIG. 13 is a cross-sectional view illustrating a lower urging member according to a sixth embodiment, and corresponding to the cross section taken along the line VII-VII in FIG. 6.

### PREFERRED MODE FOR CARRYING OUT THE INVENTION

### First Embodiment

A first embodiment will be described with reference to the drawings.

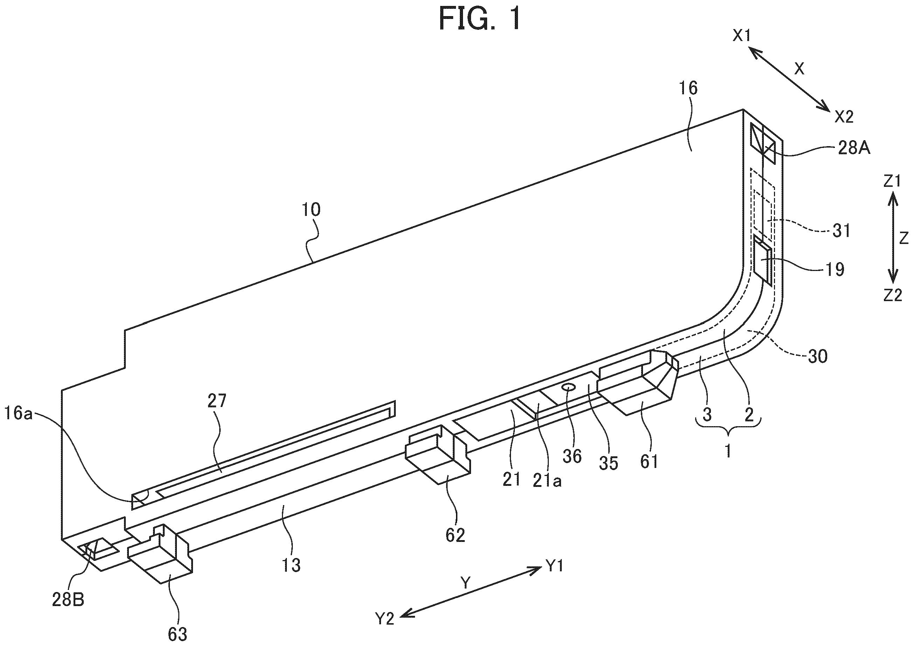

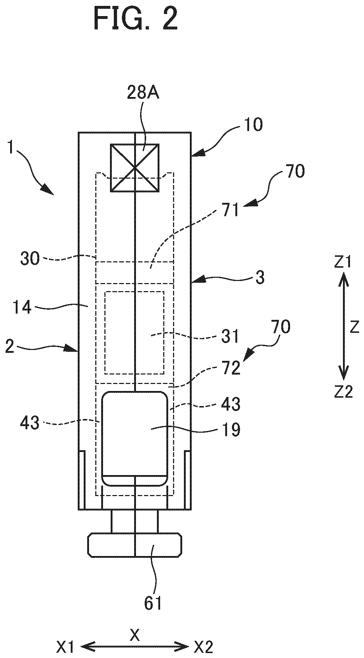

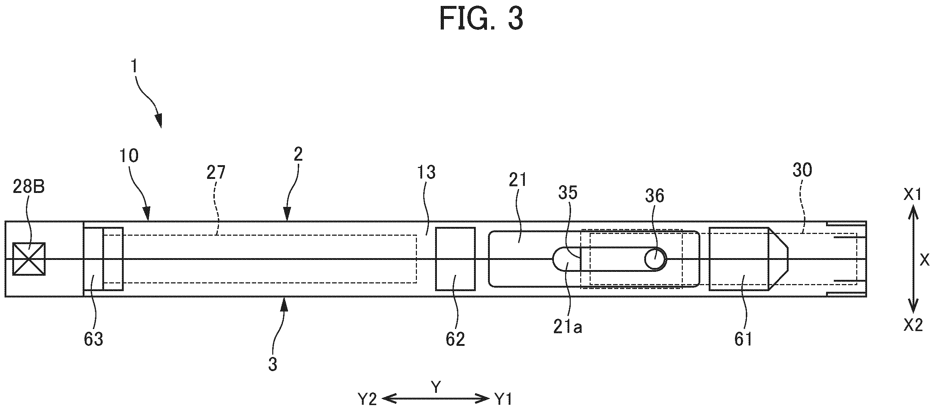

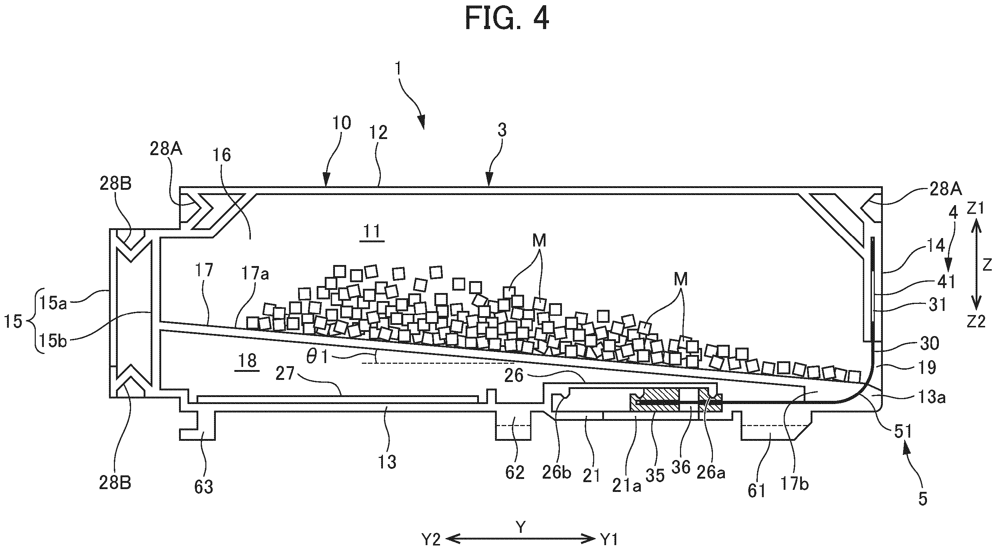

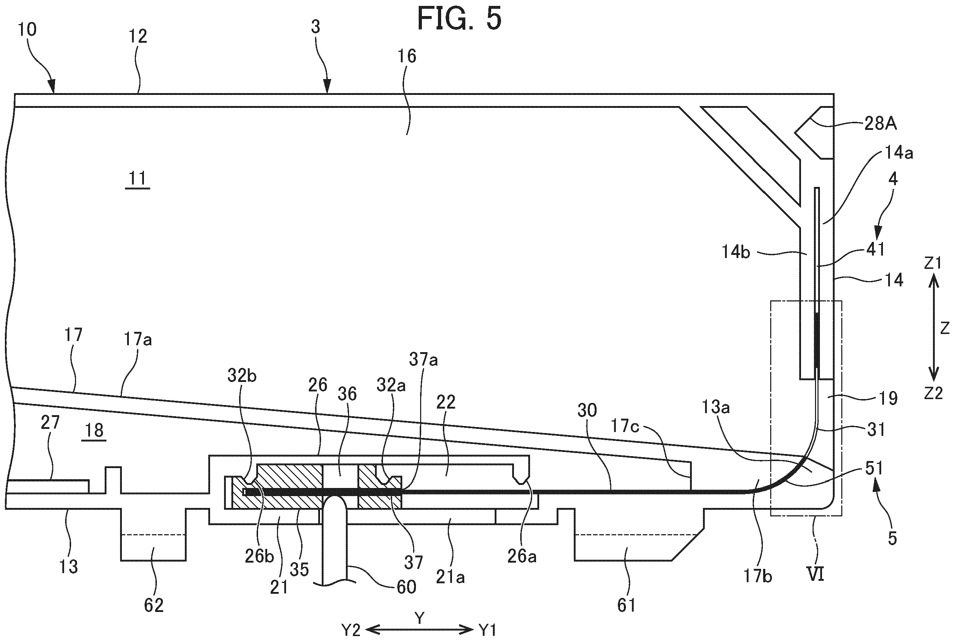

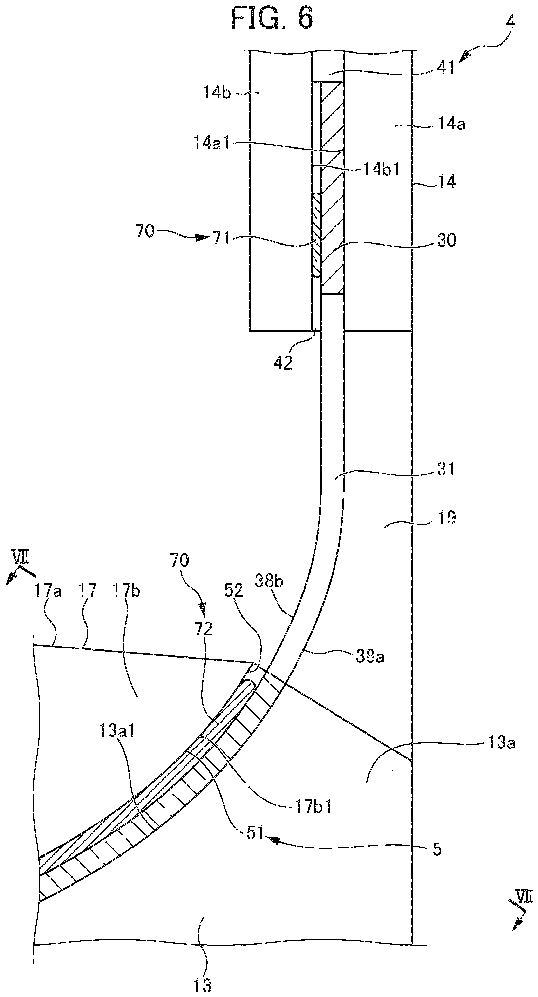

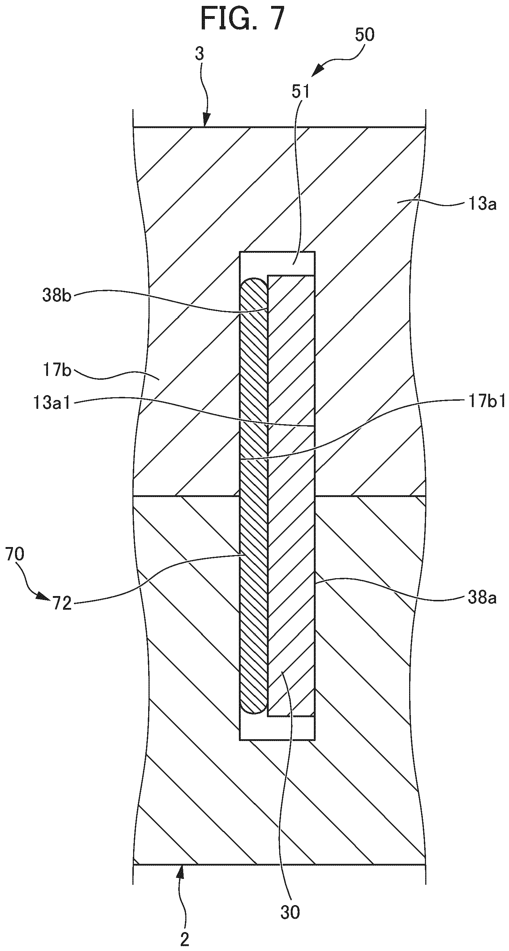

FIG. 1 is a perspective view of a case 1 according to the first embodiment as viewed from below. FIG. 2 is a front view of the case 1 as viewed from front. FIG. 3 is a bottom view of the case 1. FIG. 4 is a diagram illustrating the interior of the case 1 as viewed from a side. FIG. 5 is diagram illustrating the interior of a front portion of the case 1 as viewed from a side. FIG. 6 illustrates the portion VI in FIG. 5 on an enlarged scale. FIG. 7 illustrates a portion of a cross section taken along the line VII-VII in FIG. 6.

As illustrated in FIG. 4, the case 1 accommodates therein a plurality of electronic components M in bulk as components. The case 1 having the plurality of electronic components M accommodated therein is set to a feeder (not shown), and the electronic components M are discharged from the case 1 due to vibration of the feeder and supplied to a mounting device or the like. The electronic component M of the present embodiment is, for example, a minute rectangular parallelepiped electronic component having a length of 1.2 mm or less in the longitudinal direction. Examples of such an electronic component include a capacitor, an inductor, etc., but the present embodiment is not limited thereto.

Arrows X, Y, and Z in the drawings to which reference is made respectively indicate the left-right direction (width direction), the front-rear direction, and the up-down direction of the case 1 in a use state where the case 1 is set to the feeder. The left side in the left-right direction X is denoted by X1, the right side is denoted by X2. The front side in the front-rear direction Y is denoted by Y1, the rear side is denoted by Y2. The upper side in the up-down direction Z is denoted by Z1, and the lower side is denoted by Z2. In the following description, the left-right direction, the front-rear direction, and the up-down direction are based on the directions indicated by the arrows.

As illustrated in FIGS. 1 to 4, the case 1 includes a case body 10 in which the plurality of electronic components M are accommodated, and a shutter member 30.

As illustrated in FIG. 1, the case body 10 includes a first member 2 and a second member 3 that are separable in left-right direction. The first member 2 and the second member 3 are molded bodies made of resin such as ABS resin or the like. The first member 2 and the second member 3 are combined with and joined to each other to thereby form the case body 10. Example of a process for joining the first member 2 and the second member 3 include, but are not limited to, ultrasonic bonding and bonding with an adhesive.

FIG. 4 illustrates the interior of the second member 3 situated on the right side, while the first member 2 situated on the left side is omitted. The case body 10 has a flat box shape that is long in the front-rear direction and thin in the left-right direction. In the following description, except where necessary, the first member 2 and the second member 3 will not be individually described, and the configuration including the first member 2 and the second member 3 joined to each other will be described.

As illustrated in FIG. 4, the case body 10 includes a top plate 12 and a bottom plate 13 that extend in the front-rear direction, a front wall 14 and a rear wall 15 that extend in the up-down direction, a pair of left and right side walls 16, and an inclined plate 17 that partitions the interior of the case body 10 into upper and lower spaces. The rear wall 15 includes an outer rear wall 15a forming an outer surface and an inner rear wall 15b provided forward of the outer rear wall 15a. An accommodating space 11 for accommodating the plurality of electronic components M in bulk is formed in the case body 10.

The electronic components M accommodated in the accommodating space 11 are discharged through a discharge port 19 to the outside of the case body 10. The discharge port 19 is provided in a lower portion of the front wall 14. The discharge port 19 is a rectangular opening. The discharge port 19 is not limited to the rectangular shape, and may have, for example, a circular shape, an elliptical shape, or the like. The discharge port 19 is opened and closed by the shutter member 30.

The inclined plate 17 extends between the left and right side walls 16 and extends from the inner rear wall 15b to a lower portion of the discharge port 19. The inclined plate 17 is arranged below the center in the up-down direction of the interior of the case body 10. In the interior of the case body 10, the space above the inclined plate 17 serves as the accommodating space 11, and the space below the inclined plate 17 serves as a lower space 18.

As illustrated in FIG. 4, the inclined plate 17 is inclined downward toward the discharge port 19, and has an upper surface that is denoted as an inclined surface 17a and inclined downward toward the discharge port 19. In the present embodiment, the inclined surface 17a is inclined by an inclination angle θ1 of about 10° with respect to the horizontal direction in a state in which the case 1 is set to the feeder. The inclination angle θ1 of the inclined surface 17a is preferably 3° or greater and 10° or less. The inclination angle θ1 of the inclined surface 17a is appropriately adjusted in accordance with, for example, vibration conditions of the feeder. The inclined plate 17 has, in a lower portion of a front end thereof, an upper guide protrusion 17b that forms part of a lower guide 5, which will be described later.

As illustrated in FIG. 4, a radio frequency identification (RFID) tag 27 having a strip shape elongated in the front-rear direction is disposed in a rear portion of the lower space 18. The RFID tag 27 is configured as an adhesive label, for example, and is attached to the upper surface of the bottom plate 13. The RFID tag 27 is placed into the lower space 18 through a hole 16a formed in the side wall 16 shown in FIG. 1 and extending in the front-rear direction. The RFID tag 27 has a known configuration including a transmitter/receiver, a memory, an antenna, and the like. For example, the feeder, to which the case 1 is set, includes a reader/writer that reads and writes information from and to the RFID tag 27.

The case body 10 includes upper gripping portions 28A and rear gripping portions 28B. The upper gripping portions 28A are a pair of front and rear recesses formed at front and rear ends of an upper portion of the case body 10. The rear gripping portions 28B are a pair of upper and lower recesses formed at upper and lower ends of a rear portion of the case body 10. When the case 1 is carried by a robot hand, for example, the upper gripping portions 28A or the rear gripping portions 28B are gripped by the robot hand.

The case body 10 has, on a bottom surface thereof, a plurality of claws that allow for detachably setting the case 1 to the feeder. In the present embodiment, a first claw 61, a second claw 62, and a third claw 63 are provided on the bottom surface at intervals in the front-rear direction. The first claw 61, the second claw 62, and the third claw 63 are formed integrally with the case body 10. Each of the first claw 61 and the second claw 62 is constituted by a T-shaped slot having an inverted T-shaped cross section in a plane extending in the up-down direction and the left-right direction. The third claw 63 is a plate-like piece extending rearward and having an L-shape in a side view.

The shutter member 30 slides to open and close the discharge port 19. The shutter member 30 continuously extends from the upper surface of the bottom plate 13 to the interior of the front wall 14, and is slidable in the extending direction in which it extends. The bottom plate 13 has, at a front end thereof, a lower guide protrusion 13a that forms part of the lower guide 5, which will be described later.

The shutter member 30 is an elongated strip-shaped film member having a constant width. The shutter member 30 is made of a flexible material having a certain degree of rigidity and being bendable, such as PET (polyethylene terephthalate). The shutter member 30, which is made of such a film-shaped member, may have any thickness, but the thickness is preferably 0.1 mm or greater and 0.5 mm or less, for example. The shutter member 30 has a width that is slightly larger than the width of the discharge port 19, and is capable of covering the discharge port 19 without a gap. The shutter member 30 has, in a front end portion thereof, an opening 31 having substantially the same shape as the discharge port 19.

The shutter member 30 can slide along an upper guide 4 and the lower guide 5 that belong to the case body 10. The upper guide 4 is disposed above the discharge port 19, and the lower guide 5 is disposed below the inclined plate 17. A front portion of the shutter member 30 slides in the up-down direction along the upper guide 4, and a rear portion of the shutter member 30 slides in the substantially horizontal direction along the lower guide 5. The upper guide 4 and the lower guide 5 each form a passage that slidably holds the shutter member 30 while maintaining the plane direction of the shutter member 30 along the left-right direction. Details of the upper guide 4 and the lower guide 5 will be described later.

The shutter member 30 is slid by means of a slide member 35. As illustrated in FIG. 4, the slide member 35 is disposed on a rear end portion of the shutter member 30.

As illustrated in FIGS. 4 and 5, the bottom plate 13 of the case body 10 has a protruding plate part 21 in a front portion thereof. The protruding plate part 21 protrudes downward and extends in the front-rear direction. The protruding plate part 21 has a long hole 21a extending in the front-rear direction. A plate part 26 is disposed above the protruding plate part 21 with a predetermined space 22 provided therebetween. The plate part 26 is substantially parallel to the protruding plate part 21, and is formed integrally with the bottom plate 13. The space 22 is surrounded by the protruding plate part 21, the plate part 26, and the left and right side walls 16. The slide member 35 is disposed in the space 22. The plate part 26 has, at a front end thereof, a front protrusion 26a protruding downward. The plate part 26 has, at a rear end thereof, a rear protrusion 26b protruding downward.

The slide member 35 is a rectangular plate-like piece elongated in the front-rear direction. The slide member 35 has a circular operation hole 36 penetrating through the slide member 35 in the up-down direction. The operation hole 36 communicates with the long hole 21a of the case body 10, and is exposed to the outside through the long hole 21a.

As illustrated in FIG. 5, the slide member 35 has a slit 37 formed in a middle in the up-down direction of the slide member 35, extending in the front-rear direction, and opening at the front side of the slide member 35. The slit 37 has a front end opening 37a at the front end thereof, and the shutter member 30 has the rear end portion inserted in the slit 37 through the front end opening 37a. The slit 37 has a closed rear end. The slit 37 may open at the left and right sides of the slide member 35. The shutter member 30 is fixed to the slide member 35 by way of adhesion or the like. As a result, the shutter member 30 can slide together with the slide member 35. The slide member 35 slides along, and is guided by, the protruding plate part 21 and the plate part 26 of the bottom plate 13 and the left and right side walls 16, and thereby slidingly moves in the front-rear direction.

As illustrated in FIG. 5, the slide member 35 has a front recess 32a and a rear recess 32b in a front end portion and a rear end portion of the upper surface, respectively. When the slide member 35 slides forward, the front protrusion 26a of the plate part 26 enters and engages with the front recess 32a, whereby further forward sliding is restricted. At this time, the shutter member 30 is positioned such that the opening 31 is positioned above the discharge port 19 as illustrated in FIG. 4, and the discharge port 19 is closed by a portion of the shutter member 30 below the opening 31.

On the other hand, when the slide member 35 slides rearward, as illustrated in FIG. 5, the rear protrusion 26b of the plate part 26 enters and engages with the rear recess 32b, whereby further rearward sliding is restricted. At this time, the opening 31 of the shutter member 30 coincides with the discharge port 19, and the discharge port 19 is open.

After a predetermined number of electronic components M are charged into the accommodating space 11 through the discharge port 19, the case 1 is shipped to a supply destination of the electronic components M, while having the slide member 35 slid forward and the discharge port 19 closed by the shutter member 30. Thus, FIG. 4 illustrates the interior of the case 1 at the time of shipment. A user who receives the supply of the case 1 can open the discharge port 19 in the following manner, for example.

As illustrated in FIG. 5, the user inserts an operation pin 60 into the operation hole 36 of the slide member 35, and moves the operation pin 60 in the direction for the shutter member 30 to open the discharge port 19, i.e., in the rearward direction. As a result, the shutter member 30 slides rearward in conjunction with the slide member 35, and the opening 31 of the shutter member 30 becomes coincident with the discharge port 19, thereby opening the discharge port 19.

The mechanism for sliding the shutter member 30 to open and close the discharge port 19 is not limited to the above-described configuration in which the slide member 35 is integrated with the shutter member 30, and a different mechanism may be adopted.

In the foregoing, the basic configuration of the case 1 according to the first embodiment has been described. The case 1 is used, for example, as follows. After a predetermined number of electronic components M are charged into the accommodating space 11 of the case body 10 through the discharge port 19 opened in advance, the discharge port 19 is closed, and then, the case 1 is supplied to a predetermined supply destination. At the supply destination, as described above, the case 1 is set to the feeder and the discharge port 19 is opened, and the electronic components M are discharged through the discharge port 19 and supplied to the mounting device or the like by the vibration of the feeder.

Next, the upper guide 4 and the lower guide 5, which guide the sliding motion of the shutter member 30, and the shutter member 30 will be described in detail.

As illustrated in FIG. 5, the upper guide 4 includes an upper guide slit 41 as a guide slit that is provided above the discharge port 19 and extends in the up-down direction. The upper guide slit 41 is formed in the front wall 14. The front wall 14 includes a front plate 14a and a rear plate 14b between which the upper guide slit 41 is interposed.

As illustrated in FIG. 6, the upper guide slit 41 communicates with the discharge port 19 through an opening 42 situated at the lower end of the upper guide slit 41. The front plate 14a and the rear plate 14b have a front inner wall surface 14a1 and a rear inner wall surface 14b1, respectively, which are a pair of inner wall surfaces facing each other. The upper guide slit 41 is defined between the front inner wall surface 14a1 and the rear inner wall surface 14b1. The shutter member 30 has a front end portion inserted into the upper guide slit 41 through the opening 42, and the front end portion slides in the upper guide slit 41 in the up-down direction.

As illustrated in FIG. 5, the lower guide 5 includes a lower guide slit 51 as a guide slit provided below the discharge port 19. The lower guide slit 51 is formed between the lower guide protrusion 13a belonging to the bottom plate 13 and the upper guide protrusion 17b belonging to the inclined plate 17.

As illustrated in FIG. 6, the lower guide slit 51 communicates with the discharge port 19 through an opening 52 situated at the upper end of the lower guide slit 51. The lower guide protrusion 13a and the upper guide protrusion 17b have a lower inner wall surface 13a1 and an upper inner wall surface 17b1, respectively, which are a pair of inner wall surfaces facing each other. The lower guide slit 51 is defined between the lower inner wall surface 13a1 and the upper inner wall surface 17b1. The lower inner wall surface 13a1 on the side of the bottom plate 13 is curved to extend gently upwardly forward. The upper inner wall surface 17b1 on the side of the inclined plate 17 is curved in conformity with the lower inner wall surface 13a1 so that the thickness dimension of the lower guide slit 51 is substantially constant. Accordingly, the lower guide slit 51 is curved to extend gently upwardly forward.

A rear portion of the shutter member 30 slides in the front-rear direction immediately above the bottom plate 13. A front portion of the shutter member 30 extending over the bottom plate 13 penetrates through and slides in the lower guide slit 51, which curves in a concave shape in the front-rear direction, whereby the front portion is bent upward at an angle of approximately 90° with respect to the horizontal direction, and thereafter, transitions to a posture extending in the up-down direction.

As illustrated in FIG. 2, in a lower portion of the front wall 14, side guide slits 43 that communicate with the upper guide slit 41 and the lower guide slit 51 are provided on both left and right sides of a portion corresponding to the discharge port 19. Left and right edge portions of the shutter member 30 extending over the discharge port 19 enter the side guide slits 43. Thus, the entire discharge port 19 can be closed by the shutter member 30.

The upper guide slit 41 and the lower guide slit 51 have substantially the same thickness dimension that allows the shutter member 30 to smoothly pass therethrough and to be held thereby. For example, the thickness dimension is about 1 to 2 times as large as the thickness of the shutter member 30, and is preferably 0.1 mm or greater and 1 mm or less, for example.

As illustrated in FIGS. 6 and 7, the film-shaped shutter member 30 has a first main surface 38a and a second main surface 38b as a pair of main surfaces. Here, by referring to the position corresponding to the discharge port 19, the surface facing the front is denoted as the first main surface 38a, and the surface facing the rear is denoted as the second main surface 38b. The first main surface 38a faces downward and the second main surface 38b faces upward over the bottom plate 13.

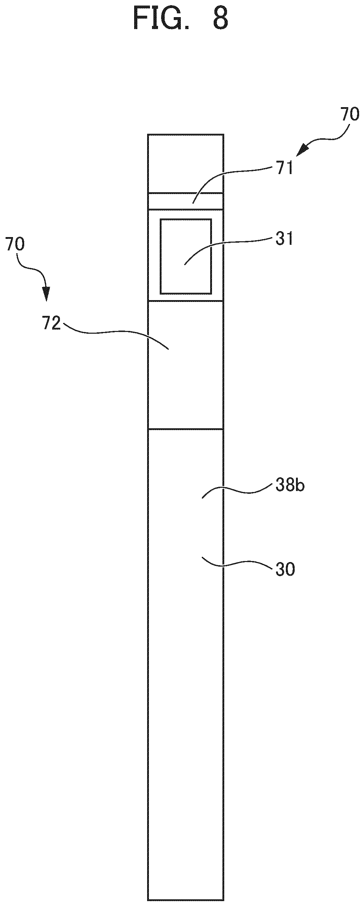

In the first embodiment, an urging member 70 is disposed on the second main surface 38b of the shutter member 30. As shown in FIGS. 6 and 8, the urging member 70 includes an upper urging member 71 disposed above the opening 31 of the shutter member 30, and a lower urging member 72 disposed below the opening 31 of the shutter member 30. Each of the upper urging member 71 and the lower urging member 72 is made of an elastic material, preferable example of which include sponge, rubber, etc. that can be compressed and exhibit elastic resilience when released from compression. The upper urging member 71 and the lower urging member 72 are joined to the second main surface 38b of the shutter member 30 by way of boding with an adhesive or the like. Thus, the upper urging member 71 and the lower urging member 72 slide together with the shutter member 30.

FIG. 8 is a plan view of the shutter member 30 over its entire length, and illustrates the second main surface 38b. As illustrated in FIG. 8, the lower urging member 72 disposed below the opening 31 has a predetermined length and a width that covers the entire width of the shutter member 30.

As illustrated in FIGS. 6 and 7, in the lower guide slit 51, the lower urging member 72 is disposed in a compressed state between the second main surface 38b of the shutter member 30 and the upper inner wall surface 17b1. The lower urging member 72 in the compressed state applies an elastic force so as to press the shutter member 30 against the lower inner wall surface 13a1. Consequently, a gap between the shutter member 30 and the upper inner wall surface 17b1 is closed by the lower urging member 72 in the vicinity of the opening 52 of the lower guide slit 51.

On the other hand, as illustrated in FIG. 8, the upper urging member 71 is disposed above the opening 31, and has a predetermined length and a width that covers the entire width of the shutter member 30. The upper urging member 71 is shorter than the lower urging member 72.

As illustrated in FIG. 6, in the upper guide slit 41, the upper urging member 71 is disposed in a compressed state between the second main surface 38b of the shutter member 30 and the rear inner wall surface 14b1. The upper urging member 71 in the compressed state applies an elastic force so as to press the shutter member 30 against the front inner wall surface 14a1. Consequently, a gap between the shutter member 30 and the rear inner wall surface 14b1 is closed by the upper urging member 71 in the vicinity of the opening 42 of the upper guide slit 41. Although illustration is omitted, the cross section of the upper guide 4 is the same as the cross section illustrated in FIG. 7.

The case 1 illustrated in FIG. 6 is in an open state in which the opening 31 of the shutter member 30 coincides with the discharge port 19 of the case 1 and the discharge port 19 is open. In this open state, the upper urging member 71 is positioned above the discharge port 19, and the lower urging member 72 is positioned below the discharge port 19. That is, the urging member 70 is positioned in proximity to the discharge port 19. In the present embodiment, the lower urging member 72 preferably has a length that covers the discharge port 19 in the closed state illustrated in FIG. 4, in which the discharge port 19 is closed by the shutter member 30.

When the shutter member 30 slides between a closing position at which the discharge port 19 is closed by the shutter member 30 and an open position at which the discharge port 19 is open, the lower urging member 72 passes across the discharge port 19. At this time, both left and right end portions of the lower urging member 72 pass through the side guide slits 43 on both sides of the discharge port 19, together with the shutter member 30. Thus, when passing across the discharge port 19, the lower urging member 72 does not obstruct the sliding movement of the shutter member 30.

As mentioned above, the case 1 having the above configuration is set to the feeder, and then, the electronic components M are discharged through the discharge port 19. At this time, in a case where the electronic component M is minute enough to enter a gap at the opening 52 of the lower guide slit 51, the electronic component M may fall through the gap into the lower guide slit 51. However, in the present embodiment, since the lower urging member 72 is positioned between the shutter member 30 and the upper inner wall surface 17b1 in the vicinity of the opening 52 of the lower guide slit 51, even if the electronic component M falls, it is received by the lower urging member 72 and prevented from entering the depth of the lower guide slit 51. This feature makes it less likely for the electronic components M to enter the lower guide slit 51 to be lost there, and enables the shutter member 30 to always slide smoothly. Furthermore, the electronic components M can be discharged smoothly through the discharge port 19.

When the discharge port 19 is closed by the shutter member 30, the discharge port 19 is covered by the lower urging member 72, and no gap is formed at the opening 42 of the upper guide slit 41 and the opening 52 of the lower guide slit 51. Therefore, for example, even when the case 1 is carried or stored while having the discharge port 19 closed with the shutter member 30, the electronic components M are prevented from entering both the upper guide slit 41 and the lower guide slit 51. This feature reduces the tendency of the electronic components M to be lost, and enables the shutter member 30 to always slide smoothly.

During sliding of the shutter member 30, a part of the discharge port 19 adjacent to the lower guide slit 51 is covered with the lower urging member 72, and the upper urging member 71 is positioned in the upper guide slit 41 above the discharge port 19. Therefore, even if the electronic component M enters the upper guide slit 41 through a gap at the opening 42, the upper urging member 71 prevents the electronic component M from entering deeper. Since the opening 52 of the lower guide slit 51 is covered with the lower urging member 72, the electronic components M are prevented from entering the lower guide slit 51. This feature reduces the tendency of the electronic components M to be lost, and enables the shutter member 30 to always slide smoothly.

The case 1 according to the first embodiment described above includes: the case body 10 that accommodates a plurality of electronic components M and has the discharge port 19 through which the electronic components M are discharged; the upper guide slit 41 and the lower guide slit 51 as guide slits that are formed in the case body 10 and communicate with the discharge port 19; and the shutter member 30 that is slidably inserted into the upper guide slit 41 and the lower guide slit 51 and slides to open and close the discharge port 19. The case body 10 has the front inner wall surface 14a1 and the rear inner wall surface 14b1 as a pair of inner wall surfaces facing each other to define the upper guide slit 41 therebetween, and the lower inner wall surface 13a1 and the upper inner wall surface 17b1 as a pair of inner wall surfaces defining the lower guide slit 51 therebetween. The shutter member 30 has the first main surface 38a and a second main surface 38b as a pair of main surfaces each facing a respective one of each of the pairs of inner wall surfaces. The shutter member 30 has the urging member 70 disposed thereon and configured to elastically urge the shutter member 30 toward at least one of each of the pairs of inner wall surfaces, and the urging member 70 includes the upper urging member 71 and the lower urging member 72.

Thus, the upper urging member 71 and the lower urging member 72 make it less likely for the electronic components M accommodated in the case 1 to enter the upper guide slit 41 and the lower guide slit 51. This feature reduces the tendency of the electronic components M to be lost and facilitates smooth discharge of the electronic components M through the discharge port 19.

In the case 1 according to the first embodiment, the upper urging member 71 and the lower urging member 72 are disposed on the second main surface 38b, which is one of the main surfaces of the shutter member 30. The upper urging member 71 presses the shutter member 30 against the front inner wall surface 14a1 in the upper guide slit 41, and the lower urging member 72 presses the shutter member 30 against the lower inner wall surface 13a1 in the lower guide slit 51. The upper urging member 71 is positioned between the shutter member 30 and the rear inner wall surface 14b1 in the upper guide slit 41, and the lower urging member 72 is positioned between the shutter member 30 and the upper inner wall surface 17b1 in the lower guide slit 51.

Thus, the upper urging member 71 and the lower urging member 72 make it less likely for the electronic components M accommodated in the case 1 to enter the upper guide slit 41 and the lower guide slit 51, thereby reducing the tendency of the electronic components M to be lost, and facilitating smooth discharge of the electronic components M through the discharge port 19.

In the case 1 according to the first embodiment, the upper urging member 71 and the lower urging member 72 are preferably positioned in proximity to the discharge port 19.

Thus, when the electronic components M are discharged through the discharge port 19 in the open state in which the opening 31 of the shutter member 30 coincides with the discharge port 19, the upper urging member 71 and the lower urging member 72 make it less likely for the electronic components M to enter the upper guide slit 41 and the lower guide slit 51. This feature reduces the tendency of the electronic components M to be lost and facilitates smooth discharge of the electronic components M through the discharge port 19.

Now, second to sixth embodiments will be described as other embodiments. The second to sixth embodiments are the same as the first embodiment except for some modifications made to the respective embodiment. Therefore, in the following description, the same components as those of the first embodiment are denoted by the same reference signs, and the description thereof will be omitted, and the modifications will be mainly described.

### Second Embodiment

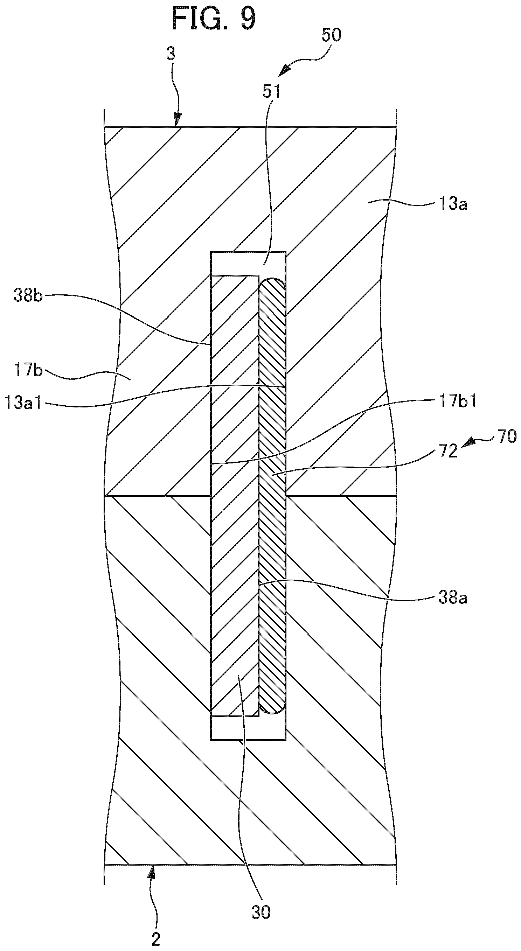

FIG. 9 illustrates the second embodiment and is a cross-sectional view corresponding to the cross section taken along the line VII-VII in FIG. 6 of the first embodiment.

As illustrated in FIG. 9, in the second embodiment, the lower urging member 72 positioned in the lower guide slit 51 is disposed on the first main surface 38a of a shutter member 30. In the lower guide slit 51, the lower urging member 72 in a compressed state is positioned between the first main surface 38a of the shutter member 30 and the lower inner wall surface 13a1. The lower urging member 72 in the compressed state applies an elastic force so as to press the shutter member 30 against the upper inner wall surface 17b1. Although not shown, also in the upper guide slit 41, the upper urging member 71 disposed on the first main surface 38a of the shutter member 30 presses the shutter member 30 against the rear inner wall surface 14b1.

According to the second embodiment, the upper urging member 71 and the lower urging member 72 make it less likely for the electronic components M accommodated in the case 1 to enter the upper guide slit 41 and the lower guide slit 51. This feature reduces the tendency of the electronic components M to be lost and facilitates smooth discharge of the electronic components M through the discharge port 19.

### Third Embodiment

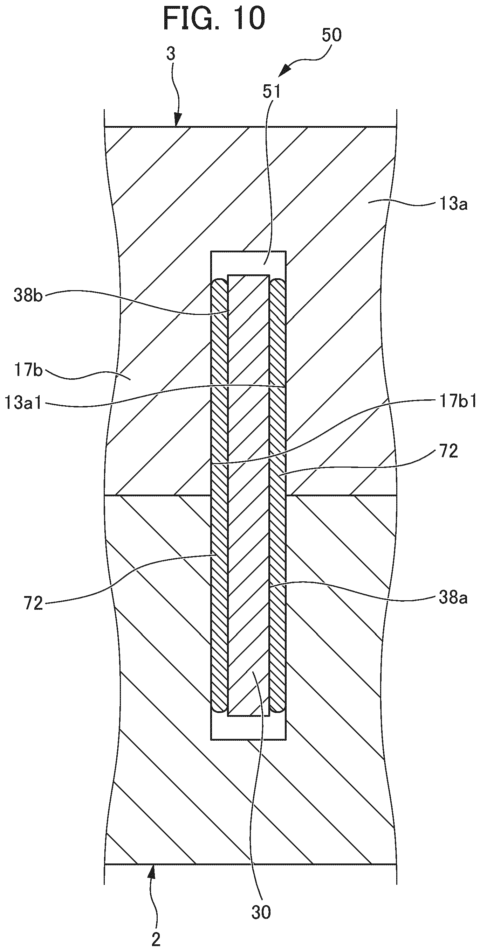

FIG. 10 illustrates the third embodiment and is a cross-sectional view corresponding to the cross section taken along the line VII-VII in FIG. 6 of the first embodiment.

As illustrated in FIG. 10, in the third embodiment, the lower urging member 72 positioned in the lower guide slit 51 includes a pair of lower urging members 72 disposed on the first main surface 38a and the second main surface 38b of the shutter member 30, respectively. The shutter member 30 is disposed between the upper inner wall surface 17b1 and the lower inner wall surface 13a1, via the pair of lower urging members 72. The lower urging member 72 on the first main surface 38a is sandwiched between the first main surface 38a and the lower inner wall surface 13a1 while being in a compressed state. The lower urging member 72 on the second main surface 38b is sandwiched between the second main surface 38b and the upper inner wall surface 17b1 while being in a compressed state. Although not shown, also in the upper guide slit 41, a pair of upper urging members 71 in a compressed state are disposed on the first main surface 38a and the second main surface 38b of the shutter member 30, respectively, and the shutter member 30 sandwiched between the pair of upper urging members 71 is disposed between the front inner wall surface 14a1 and the rear inner wall surface 14b1.

According to the third embodiment, the pair of upper urging members 71 and the pair of lower urging members 72 disposed on the first main surface 38a and the second main surface 38b of the shutter member 30 make it less likely for the electronic components M accommodated in the case 1 to enter the upper guide slit 41 and the lower guide slit 51. This feature reduces the tendency of the electronic components M to be lost and facilitates smooth discharge of the electronic components M through the discharge port 19.

### Fourth Embodiment

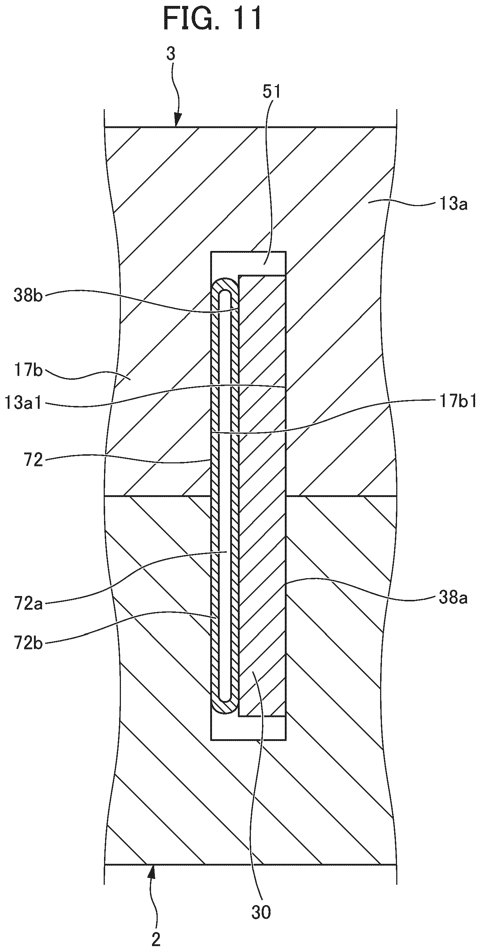

FIG. 11 illustrates the fourth embodiment and is a cross-sectional view corresponding to the cross section taken along the line VII-VII in FIG. 6 of the first embodiment.

As illustrated in FIG. 11, in the fourth embodiment, the lower urging member 72 positioned in the lower guide slit 51 is disposed only on the second main surface 38b of the shutter member 30 as in the first embodiment, but the lower urging member 72 of the fourth embodiment has a structure including a hollow portion 72a. In the present embodiment, the hollow portion 72a is formed over substantially the entire width and the entire length of the lower urging member 72, and is surrounded by an envelope member 72b made of an airtight material such as rubber and having a substantially constant wall thickness. Compressed air sealed in the hollow portion 72a can impart an elastic force to the lower urging member 72. The lower urging member 72 in a compressed state presses the shutter member 30 against the upper inner wall surface 17b1.

In the fourth embodiment, the lower urging member 72 has the hollow structure. The hollow structure suppresses an increase in weight of the lower urging member 72, thereby making it possible to suppress an increase in weight of the entre case 1 while reducing the tendency of the electronic components M to be lost and facilitating smooth discharge of the electronic components M.

The hollow urging member can also be applied to the upper urging member 71 of the first embodiment, the upper urging member 71 and the lower urging member 72 of the second and third embodiments.

### Fifth Embodiment

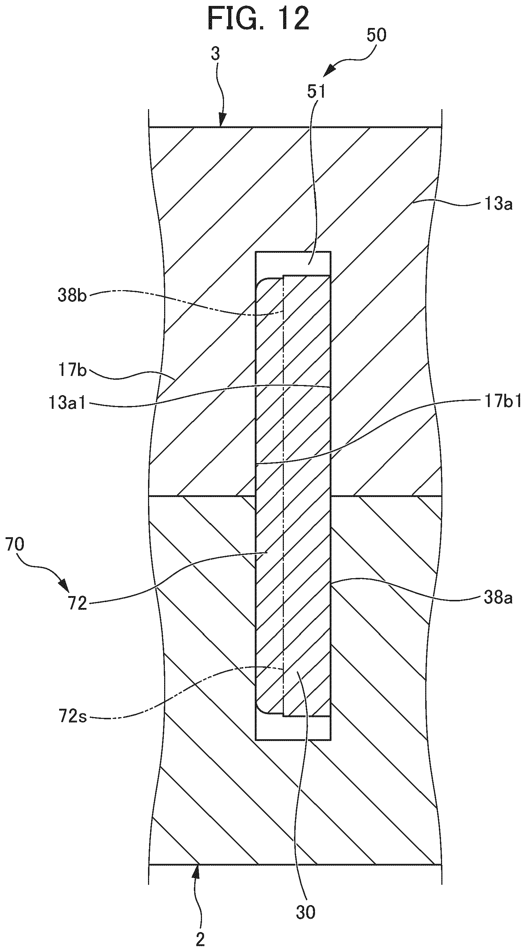

FIG. 12 illustrates the fifth embodiment and is a cross-sectional view corresponding to the cross section taken along the line VII-VII in FIG. 6 of the first embodiment.

As illustrated in FIG. 12, in the fifth embodiment, the lower urging member 72 positioned in the lower guide slit 51 is disposed only on the second main surface 38b of the shutter member 30 as in the first embodiment, but the lower urging member 72 of the fifth embodiment is made of the same material as the shutter member 30 and is formed integrally with the shutter member 30. The chain line 72s shown in FIG. 12 indicates the boundary between the lower urging member 72 and the shutter member 30. In this case, the shutter member 30 and the lower urging member 72, which are integrated with each other, are made of an elastic resin, for example.

In the fifth embodiment, the lower urging member 72 is made of the same material as the shutter member 30, and is formed integrally with the shutter member 30.

Thus, the lower urging member 72 can be formed simultaneously with the shutter member 30, whereby the manufacturing efficiency is improved.

The urging member integrated with the shutter member 30 can also be applied to the upper urging member 71 of the first embodiment and the upper urging member 71 and the lower urging member 72 of the second to fourth embodiments.

### Sixth Embodiment

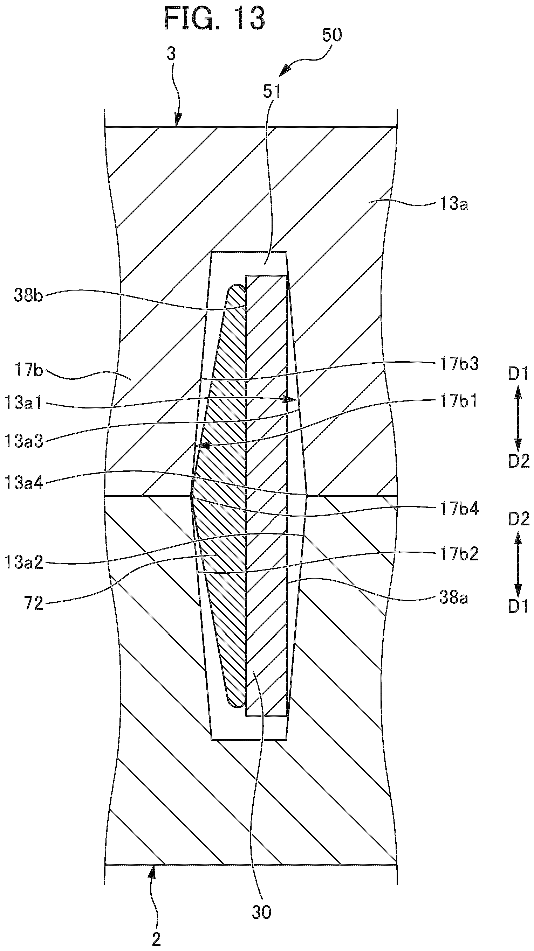

FIG. 13 illustrates the sixth embodiment and is a cross-sectional view corresponding to the cross section taken along the line VII-VII in FIG. 6 of the first embodiment.

In the sixth embodiment, there is a difference in the details of the shape of the case body 10. As described above, the case body 10 is formed by combining the first member 2 and the second member 3, which are resin molded bodies arranged on the left and right. In the case of this type of resin molded body, a contact surface with the mold may be formed into a tapered shape as necessary in order to facilitate demolding by preventing formation of an undercut that can be caught by the mold at the time of removal of the molded body from the mold.

For example, as illustrated in FIG. 13, the lower inner wall surface 13a1 of the lower guide 5 is composed of a lower inner wall surface 13a2 belonging to the first member 2 and a lower inner wall surface 13a3 belonging to the second member 3, and the lower inner wall surfaces 13a2 and 13a3 are both tapered surfaces so that the lower guide slit 51 widens in a direction D2 that is opposite to a demolding direction D1.

Furthermore, the upper inner wall surface 17b1 of the lower guide 5 is composed of an upper inner wall surface 17b2 belonging to the first member 2 and an upper inner wall surface 17b3 belonging to the second member 3, and the upper inner wall surfaces 17b2 and 17b3 are both tapered surfaces so that the lower guide slit 51 widens in the direction D2 that is opposite to the demolding direction D1. Accordingly, the lower inner wall surface 13a1 and the upper inner wall surface 17b1 each define a groove having an isosceles triangular cross section. The lower inner wall surface 13a1 and the upper inner wall surface 17b1 have a groove bottom 13a4 and a groove bottom 17b4 at the center in the width direction, respectively.

In the upper guide 4, the front inner wall surface 14a1 and the rear inner wall surface 14b1 of the first member 2 and the second member 3 may also be formed in a tapered shape, but illustration thereof is omitted herein.

In the sixth embodiment, the lower urging member 72 that is positioned in the lower guide slit 51 has a thickness that is largest at the substantially center in a width direction of the second main surface 38b and gradually decreases toward both sides in the width direction. The width direction as used herein is a direction orthogonal to the sliding direction of the shutter member 30, and is the vertical direction of the page of FIG. 13. The lower urging member 72 is positioned between the second main surface 38b of the shutter member 30 and the upper inner wall surface 17b1 while being in a compressed state, and is in contact with a groove bottom 17b4 of the groove defined by the upper inner wall surface 17b1.

On the side of the second main surface 38b on which the lower urging member 72 is disposed, a clearance between the second main surface 38b and the upper inner wall surface 17b1 is the largest at the center in the width direction where the groove bottom 17b4 is located, and gradually decreases toward both sides in the width direction. The thickness of the lower urging member 72 is the largest at the center that corresponds to where the clearance is the largest. That is, the thickness of the lower urging member 72 is the largest at the center in the width direction where the electronic components M tends to enter. This makes it less likely for the electronic components M to enter the lower guide slit 51. This feature reduces the tendency of the electronic components M to be lost and facilitates smooth discharge of the electronic components M through the discharge port 19.

This configuration in which the thickness is made largest at the center in the width direction can also be applied to the upper urging member 71.

It should be noted that the present invention is not limited to the plurality of embodiments described above, and modifications and improvements which are made without departing from the spirit of the present invention are encompassed in the scope of the present invention.

For example, the urging member 70 for urging the shutter member 30 toward the inner wall surface may be a spring made of metal, resin, or the like.

The urging member 70 is not limited to a member that presses the shutter member 30 against the inner wall surface as long as the urging member 70 urges the shutter member 30 toward the inner wall surface to make it less likely for the electronic components M to enter the upper guide slit 41 and the lower guide slit 51.

The urging member 70 may be disposed at any position on the shutter member 30 as long as the urging member 70 can make it less likely for the electronic components M to enter the upper guide slit 41 and the lower guide slit 51.

### EXPLANATION OF REFERENCE NUMERALS

1: Case
10: Case body
13a1: Lower inner wall surface (inner wall surface)
14a1: Front inner wall surface (inner wall surface)
14b1: Rear inner wall surface (inner wall surface)
17b1: Upper inner wall surface (inner wall surface)
19: Discharge port
30: Shutter member
38a: First main surface (main surface)
38b: Second main surface (main surface)
41: Upper guide slit (guide slit)
51: Lower guide slit (guide slit)
70: Urging member
M: Electronic component (component)

## Claims

1. A case comprising:
a case body configured to accommodate a plurality of components and having a discharge port through which the components are discharged;
a guide slit formed in the case body and communicating with the discharge port; and
a shutter member slidably inserted into the guide slit and configured to slide to open and close the discharge port,
the case body having a pair of inner wall surfaces that face each other and define the guide slit therebetween,
the shutter member having a pair of main surfaces that face the pair of inner wall surfaces, respectively, and including an urging member,
the urging member being configured to elastically urge the shutter member toward at least one of the pair of the inner wall surfaces.

2. The case according to claim 1, wherein
the urging member is disposed on one of the pair of main surfaces, presses the shutter member against one of the pair of inner wall surfaces, and is situated between the shutter member and an other of the pair of inner wall surfaces.

3. The case according to claim 1, wherein
the urging member includes a pair of urging members disposed on the pair of main surfaces, respectively, the shutter member is disposed between the pair of inner wall surfaces via the pair of urging members, and one of the pair of urging members is situated between one of the pair of the inner wall surfaces and the shutter member, and an other of the pair of urging members is situated between an other of the pair of the inner wall surfaces and the shutter member.

4. The case according to any one of claims 1 to 3, wherein the urging member has a hollow structure.

5. The case according to any one of claims 1 to 4, wherein
the urging member and the shutter member are made of a same material, and are formed integrally with each other.

6. The case according to any one of claims 1 to 5, wherein
the urging member has a thickness that is largest at a substantially center of the urging member in a width direction orthogonal to a sliding direction in which the shutter member slides.

7. The case according to any one of claims 1 to 6, wherein
The urging member is positioned in proximity to the discharge port.
